# EUROPEAN PATENT APPLICATION

(11) **EP 4 564 619 A1**
(43) Date of publication of application: **04.06.2025**
(21) Application number: 23845930.9
(22) Date of filing: 25.04.2023
(51) Int. Cl.: H01S 5/11, H01S 5/183

(54) **PHOTONIC CRYSTAL SURFACE-EMITTING LASER AND METHOD FOR MANUFACTURING SAME**

(30) Priority: 29.07.2022 JP 2022121596
(71) Applicant: SUMITOMO ELECTRIC INDUSTRIES, LTD., Osaka-shi, Osaka 541-0041 (JP); Kyoto University, Kyoto-shi, Kyoto 606-8501 (JP)
(72) Inventor: ITO, Yuki, Osaka-shi, Osaka 541-0041 (JP); KONO, Naoya, Osaka-shi, Osaka 541-0041 (JP); NODA, Susumu, Kyoto-shi, Kyoto 606-8501 (JP); DE ZOYSA, Menaka, Kyoto-shi, Kyoto 606-8501 (JP); YOSHIDA, Masahiro, Kyoto-shi, Kyoto 606-8501 (JP); INOUE, Takuya, Kyoto-shi, Kyoto 606-8501 (JP); ISHIZAKI, Kenji, Kyoto-shi, Kyoto 606-8501 (JP)
(74) Representative: Grünecker Patent- und Rechtsanwälte PartG mbB
(86) International application number: PCT/JP2023/016338
(87) International publication number: WO 2024/024190

(57) **Abstract**

This photonic crystal surface-emitting laser comprises an active layer, a photonic crystal layer, and a first semiconductor layer, wherein: the photonic crystal layer has a base material and a plurality of holes periodically arranged in the base material; the holes extend from one surface of the photonic crystal layer to the opposite surface of the photonic crystal layer; the first semiconductor layer is provided on the one surface of the photonic crystal layer; and the lengths of the holes in the <110> direction of the photonic crystal layer are smaller than the lengths of the holes in the <1-10> direction of the photonic crystal layer.

## Description

### TECHNICAL FIELD

The present disclosure relates to a photonic-crystal surface emitting laser and a method of manufacturing the same. The present disclosure claims priority based on Japanese Patent Application No. 2022-121596 filed on July 29, 2022, and the entire contents of the Japanese patent application are incorporated herein by reference.

### BACKGROUND ART

A photonic-crystal surface emitting laser (PCSEL) in which a photonic-crystal and an active layer having an optical gain are stacked is used (PTLs 1 to 3 and the like). The photonic-crystal includes a periodic structure having a refractive index different from that of the base material. By diffracting light in a plane of the photonic-crystal, light oscillates at a wavelength based on the period and is emitted in the normal direction of the plane. Since the resonator is spread out in a plane, the PCSEL is superior to the edge-emitting laser in single mode operation and high power output.

### CITATION LIST

### PATENT LITERATURE

Patent literature 1: Japanese Unexamined Patent Application Publication No. 2007-180120
Patent literature 2: Japanese Unexamined Patent Application Publication No. 2008-243962
Patent literature 3: International Publication Pamphlet No. WO2017/150387

### SUMMARY OF INVENTION

A photonic-crystal surface emitting laser according to the present disclosure includes an active layer, a photonic crystal layer, and a first semiconductor layer. The photonic crystal layer includes a base material and a plurality of holes periodically disposed in the base material, the plurality of holes extends from one plane of the photonic crystal layer to an opposite plane of the photonic crystal layer, the first semiconductor layer is provided on the one plane of the photonic crystal layer, and a length of each of the plurality of holes in a <110> direction of the photonic crystal layer is smaller than a length of each of the plurality of holes in a <1-10> direction of the photonic crystal layer.

A method of manufacturing a photonic-crystal surface emitting laser according to the present disclosure includes forming a plurality of holes periodically disposed in a base material of a photonic crystal layer, the plurality of holes extending from one plane of the photonic crystal layer to an opposite plane of the photonic crystal layer, forming a first semiconductor layer on the one plane of the photonic crystal layer, and forming an active layer. A length of each of the plurality of holes in a <110> direction of the photonic crystal layer is smaller than a length of each of the plurality of holes in a <1-10> direction of the photonic crystal layer.

### BRIEF DESCRIPTION OF THE DRAWINGS

FIG. 1 is a cross-sectional view illustrating a photonic-crystal surface emitting laser according to a first embodiment.
FIG. 2A is a top view illustrating a photonic-crystal surface emitting laser.
FIG. 2B is a bottom view illustrating a photonic-crystal surface emitting laser.
FIG. 3 is an enlarged cross-sectional view of a photonic-crystal surface emitting laser.
FIG. 4A is a plan view of a photonic crystal layer.
FIG. 4B is an enlarged view of a photonic crystal layer.
FIG. 5A is a cross-sectional view illustrating a method of manufacturing a photonic-crystal surface emitting laser.
FIG. 5B is a cross-sectional view illustrating a method of manufacturing a photonic-crystal surface emitting laser.
FIG. 6A is a cross-sectional view illustrating a method of manufacturing a photonic-crystal surface emitting laser.
FIG. 6B is a cross-sectional view illustrating a method of manufacturing a photonic-crystal surface emitting laser.
FIG. 7A is a cross-sectional view illustrating a method of manufacturing a photonic-crystal surface emitting laser.
FIG. 7B is a cross-sectional view illustrating a method of manufacturing a photonic-crystal surface emitting laser.
FIG. 8A is a plan view illustrating a photonic-crystal surface emitting laser according to a first comparative example.
FIG. 8B is a plan view illustrating a photonic-crystal surface emitting laser according to a second comparative example.
FIG. 9 is a cross-sectional view illustrating a photonic-crystal surface emitting laser according to a modification.
FIG. 10 is a plan view illustrating a photonic-crystal surface emitting laser according to a second embodiment.
FIG. 11 is a plan view illustrating a photonic-crystal surface emitting laser according to a third embodiment.
FIG. 12 is a plan view illustrating a photonic-crystal surface emitting laser according to a fourth embodiment.
FIG. 13 is a plan view illustrating a photonic-crystal surface emitting laser according to a fifth embodiment.
FIG. 14 is a plan view illustrating a photonic-crystal surface emitting laser according to a sixth embodiment.

### DETAILED DESCRIPTION

### [Problems to be Solved by Present Disclosure]

A hole is provided in a base material of a photonic crystal layer. Since the refractive index of the hole is different from the refractive index of the base material, light can be diffracted. However, dislocation may occur in the semiconductor layer provided on the photonic crystal layer having the hole. The dislocation reduces the crystallinity of the semiconductor layer, and the characteristics of the PCSEL deteriorate. Thus, it is an object of the present disclosure to provide a photonic-crystal surface emitting laser and a method of manufacturing the photonic-crystal surface emitting laser that are capable of suppressing dislocation of a semiconductor layer.

### [Advantageous Effects of Present Disclosure]

According to the present disclosure, it is possible to provide a photonic-crystal surface emitting laser capable of suppressing deterioration of characteristics and a method of manufacturing the photonic-crystal surface emitting laser.

### [Description of Embodiments of Present Disclosure]

First, the contents of embodiments of the present disclosure will be listed and explained.
(1) A photonic-crystal surface emitting laser according to an aspect of the present disclosure includes an active layer, a photonic crystal layer, and a first semiconductor layer. The photonic crystal layer includes a base material and a plurality of holes periodically disposed in the base material, the plurality of holes extends from one plane of the photonic crystal layer to an opposite plane of the photonic crystal layer, the first semiconductor layer is provided on the one plane of the photonic crystal layer, and a length of each of the plurality of holes in a <110> direction of the photonic crystal layer is smaller than a length of each of the plurality of holes in a <1-10> direction of the photonic crystal layer. The growth rate of the first semiconductor layer in the <110> direction is higher than the growth rate in the <1-10> direction. The first semiconductor layer grows fast in the <110> direction, and thus the hole is closed quickly. The hole is closed, thereby suppressing dislocation. The deterioration of characteristics of the photonic-crystal surface emitting laser is suppressed.
(2) In the above (1), a planar shape of each of the plurality of holes may have a first symmetric axis and a second symmetric axis, a length of each of the plurality of holes in a direction of the first symmetric axis may be smaller than a length of each of the plurality of holes in a direction of the second symmetric axis, and an angle between the first symmetric axis and the <110> direction of the photonic crystal layer may be 30 degrees or less. Since the angle between the first symmetric axis and the <110> direction is 30 degrees, the hole is shortened in the <110> direction. The first semiconductor layer grows fast in the <110> direction. Since the hole is closed quickly, dislocation is suppressed, and deterioration of characteristics of the photonic-crystal surface emitting laser is suppressed.
(3) In the above (1) or (2), the first symmetric axis may be parallel to the <110> direction. The hole is shortened in the <110> direction. The first semiconductor layer grows fast in the <110> direction. Since the hole is closed quickly, dislocation is suppressed, and deterioration of characteristics of the photonic-crystal surface emitting laser is suppressed.
(4) In any one of the above (1) to (3), the planar shape of each of the plurality of holes may be elliptical, and a minor axis of each of the plurality of holes may be parallel to the <110>. The hole is shortened in the <110> direction. The first semiconductor layer grows fast in the <110> direction. Since the hole is closed quickly, dislocation is suppressed, and deterioration of characteristics of the photonic-crystal surface emitting laser is suppressed.
(5) In any one of the above (1) to (4), the photonic crystal layer, the first semiconductor layer, and the photonic crystal layer may be stacked in order. The hole is closed by the first semiconductor layer. The first semiconductor layer can be made thin, and the active layer can be made close to the photonic crystal layer. The optical coupling between the active layer and the photonic crystal layer is strengthened. The diffraction of light facilitates laser oscillation at a desired wavelength.
(6) In any one of the above (1) to (4), the active layer, the photonic crystal layer, and the first semiconductor layer may be stacked in order. The deterioration of characteristics of the photonic-crystal surface emitting laser is suppressed.
(7) In any one of the above (1) to (6), the plurality of holes may be disposed in a square lattice in a plane of the photonic crystal layer, and a ratio of each of the plurality of holes to an area of the square lattice may be 3% to 30%. The deterioration of characteristics of the photonic-crystal surface emitting laser is suppressed.
(8) In any one of the above (1) to (7), the photonic crystal layer may include a plurality of first holes and a plurality of second holes, the plurality of first holes and the plurality of second holes may be periodically disposed in the base material, and either or both of the plurality of the first holes and the plurality of the second holes may each have a length in the <110> direction of the photonic crystal layer smaller than a length in the <1-10> direction of the photonic crystal layer. The first semiconductor layer grows fast in the <110> direction. Since either or both of the first hole and the second hole is closed quickly, dislocation is suppressed, and deterioration of characteristics of the photonic-crystal surface emitting laser is suppressed.
(9) In any one of the above (1) to (8), the photonic-crystal layer may contain indium gallium arsenide phosphide or aluminum indium gallium arsenide, and the first semiconductor layer may contain indium phosphide. An hole is provided in the indium gallium arsenide phosphide. The first semiconductor layer of indium phosphide grows fast in the <110> direction, and the hole is closed. The deterioration of characteristics of the photonic-crystal surface emitting laser is suppressed.
(10) A method of manufacturing a photonic-crystal surface emitting laser includes forming a plurality of holes periodically disposed in a base material of a photonic crystal layer, the plurality of holes extending from one plane of the photonic crystal layer to an opposite plane of the photonic crystal layer, forming a first semiconductor layer on the one plane of the photonic crystal layer, and forming an active layer. A length of each of the plurality of holes in a <110> direction of the photonic crystal layer is smaller than a length of each of the plurality of holes in a <1-10> direction of the photonic crystal layer. The growth rate of the first semiconductor layer in the <110> direction is higher than the growth rate in the <1-10> direction. The first semiconductor layer grows fast in the <110> direction, and thus the hole is closed quickly. The hole is closed, thereby suppressing dislocations. The deterioration of characteristics of the photonic-crystal surface emitting laser is suppressed.

### [Details of Embodiments of Present Disclosure]

Specific examples of a photonic-crystal surface emitting laser and a method of manufacturing the same according to embodiments of the present disclosure will be described below with reference to the drawings. The present disclosure is not limited to these examples, and is defined by the scope of the claims, and is intended to include all modifications within the meaning and scope equivalent to the scope of the claims.

### <First Embodiment>

### (Photonic-crystal Surface Emitting Laser)

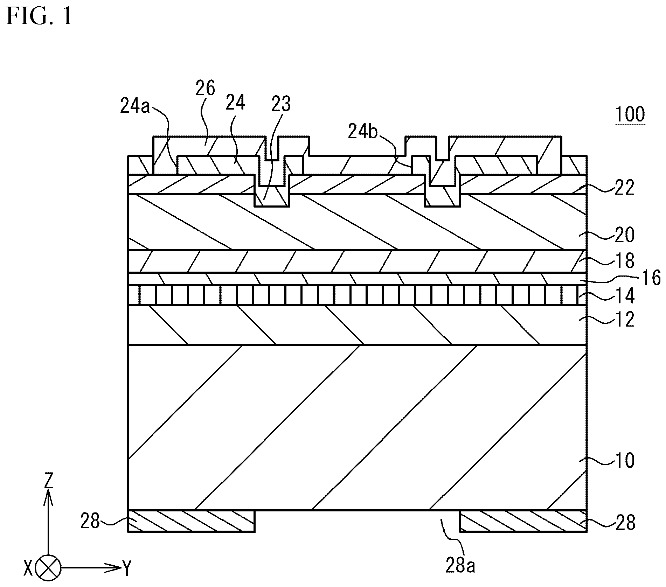

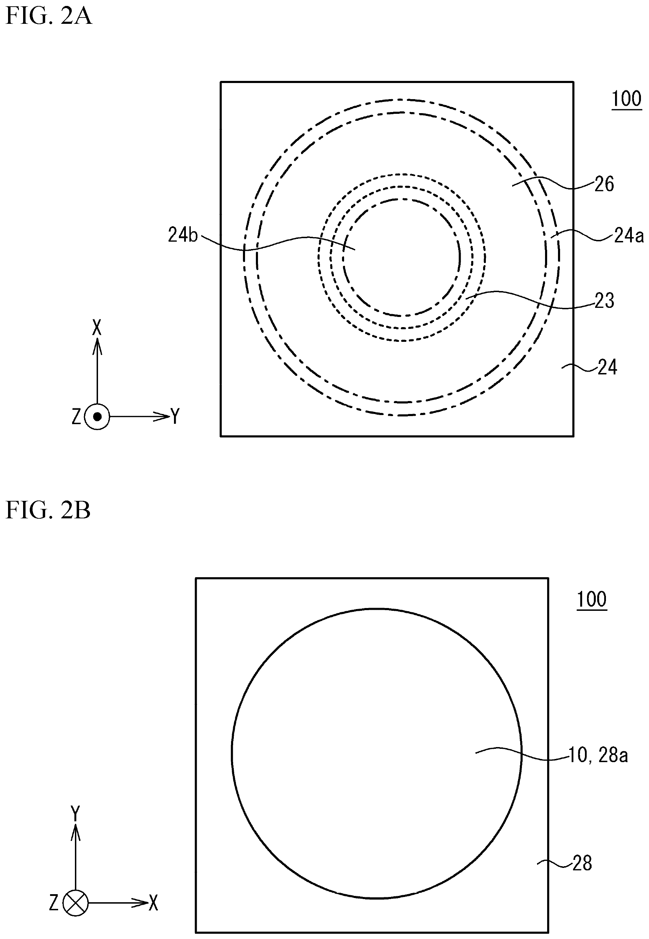

FIG. 1 is a cross-sectional view illustrating a photonic-crystal surface emitting laser 100 according to a first embodiment. FIG. 2A is a top view illustrating photonic-crystal surface emitting laser 100 and FIG. 2B is a bottom view illustrating photonic-crystal surface emitting laser 100.

As illustrated in FIG. 1, photonic-crystal surface emitting laser (PCSEL) 100 includes a substrate 10, a cladding layer 12, a photonic crystal layer 14, a cladding layer 16 (first semiconductor layer), an active layer 18, a cladding layer 20, and a contact layer 22.

The semiconductor layers are stacked along the Z-axis. Cladding layer 12, photonic crystal layer 14, cladding layer 16, active layer 18, cladding layer 20, and contact layer 22 are stacked in this order on substrate 10. The surface of each layer extends parallel to the XY plane. The X axis, the Y axis, and the Z axis are orthogonal to each other.

A recess 23 is provided in contact layer 22 and cladding layer 20. Recess 23 extends from an upper surface of contact layer 22 to a middle portion of cladding layer 20. A bottom surface of recess 23 is recessed compared to the upper surface of contact layer 22 and an upper surface of cladding layer 20. As illustrated in FIG. 2A, the planar shape of recess 23 is, for example, an annular shape.

As illustrated in FIG. 1, an insulating film 24 is provided on the upper surface of contact layer 22. Insulating film 24 covers the upper surface of contact layer 22 and is also provided inside recess 23. Insulating film 24 is formed of an insulator such as silicon nitride (SiN) or silicon oxide (SiO₂). Insulating film 24 has an opening 24a and an opening 24b. Contact layer 22 is exposed from opening 24a and opening 24b. As illustrated in FIG. 2A, the planar shape of opening 24a is, for example, an annular shape. Opening 24a is positioned outside recess 23. The planar shape of opening 24b is, for example, circular. Opening 24b is positioned inside recess 23.

As illustrated in FIG. 1, an electrode 26 is provided on insulating film 24. Electrode 26 is a p-type electrode and may be formed of, for example, titanium (Ti), platinum (Pt), or gold (Au), or may be formed of other metals. Electrode 26 is provided on the entire upper surface of insulating film 24 and is in contact with the upper surface of contact layer 22 inside opening 24a. That is, electrode 26 is electrically connected to contact layer 22. As illustrated in FIGs. 1 and 2A, an end portion (outer periphery) of electrode 26 is provided at the same position as an end portion of opening 24a.

An electrode 28 is provided on a surface of substrate 10 opposite to a surface on which cladding layer 12 is provided. Electrode 28 is an n-type electrode, and may be formed of, for example, gold (Au), germanium (Ge), or nickel (Ni), or may be formed of other metals. Electrode 28 has an opening 28a in a central portion in the XY plane. As illustrated in FIG. 2B, the planar shape of opening 28a is, for example, circular. Substrate 10 is exposed from opening 28a. Opening 28a functions as a portion (aperture) for emitting light.

Substrate 10 and cladding layers 12 and 16 are formed of, for example, n-type indium phosphide (n-InP). An n-type dopant is, for example, silicon (Si). The thickness of cladding layer 12 is, for example, 500 nm. The thickness of cladding layer 16 is, for example, 100 nm.

Cladding layer 20 is formed of, for example, p-type indium phosphide (p-InP). Contact layer 22 is formed of, for example, p-type indium gallium arsenide (p-InGaAs). A p-type dopant is, for example, zinc (Zn). The thickness of cladding layer 20 is, for example, 3 µm. The thickness of contact layer 22 is, for example, 300 nm.

Photonic crystal layer 14 is formed of, for example, n-type indium gallium arsenide phosphide (InGaAsP) or aluminum indium gallium arsenide (AlInGaAs). The thickness of photonic crystal layer 14 is, for example, 300 nm.

Active layer 18 includes a plurality of well layers and barrier layers, and has a Multi Quantum Well (MQW) structure. The well layer and the barrier layer are formed of, for example, undoped indium gallium arsenide phosphide (InGaAsP) or aluminum gallium indium arsenide (AlGaInAs). The materials described above are examples, and each layer may be formed of other materials, or may be formed of a combination of the materials described above and other materials.

The refractive index of active layer 18 is, for example, 3.5. The refractive index of each of cladding layers 12, 16 and 20 is, for example, 3.2. The refractive index of InGaAsP, which is a base material of photonic crystal layer 14, is higher than that of cladding layers 12, 16, and 20, and is, for example, 3.4.

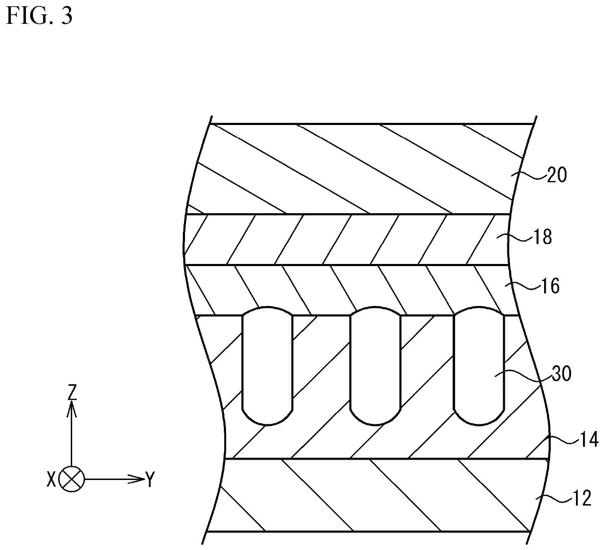

FIG. 3 is an enlarged cross-sectional view of photonic-crystal surface emitting laser 100, and illustrates cladding layer 12 through cladding layer 20. As illustrated in FIG. 3, photonic crystal layer 14 includes a plurality of holes 30. Hole 30 extends from a plane of photonic crystal layer 14 on which cladding layer 16 is provided (an upper plane in FIG. 3) to an opposite plane of photonic crystal layer 14 (a lower plane in FIG. 3), and extends, for example, partway into photonic crystal layer 14. The inside of hole 30 is air. The refractive index of hole 30 is different from the refractive index of the base material of photonic crystal layer 14.

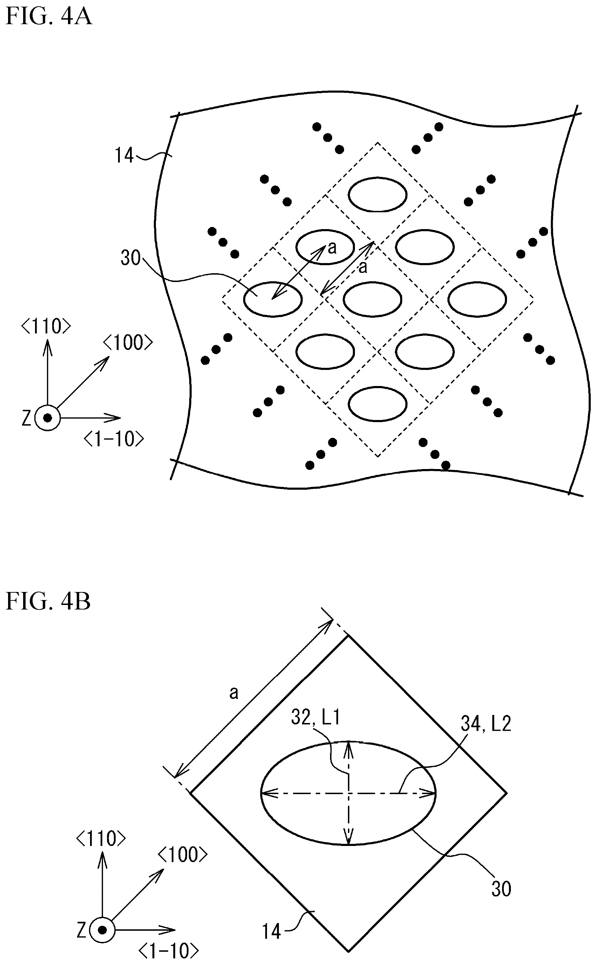

FIGs. 4A and 4B are plan views of photonic crystal layer 14. FIG. 4A illustrates a plane including a plurality of holes. FIG. 4B illustrates one hole. In FIGs. 4A and 4B, the <110> direction of photonic crystal layer 14 is oriented upward. The <1-10> direction is oriented to the right. The <100> direction is inclined by 45 degrees with respect to the <110> direction and the <1-10> direction.

As illustrated in FIG. 4A, the plurality of holes 30 are periodically arranged in the upper plane of photonic crystal layer 14. The plurality of holes 30 are disposed in a square lattice. In FIG. 4A, the square lattice is indicated by a dotted line. The sides of the square lattice are inclined by 45 degrees with respect to the <110> direction and the <1-10> direction, and are oriented to the <100> direction. Hole 30 and the square lattice are periodically arranged in the <100> direction. The number of holes 30 is, for example, several tens or several hundreds.

A distance (period) a between the centers of adjacent holes 30 is equal to a length of the side of one square lattice. The distance a is determined in accordance with the oscillate wavelength. For example, when the oscillate wavelength is 1300 nm, the distance a is about 400 nm.

As illustrated in FIG. 4B, hole 30 is elliptical and has a minor axis 32 (first symmetric axis) and a major axis 34 (second symmetric axis). Hole 30 is line symmetric with respect to minor axis 32 and line symmetric with respect to major axis 34. Minor axis 32 is parallel to the <110> direction. Major axis 34 is parallel to the <1-10> direction. Minor axis 32 and major axis 34 are each inclined by 45 degrees from the <100> direction.

A length L1 of minor axis 32 is smaller than a length L2 of major axis 34. Length L1 of minor axis 32 is, for example, 60 nm to 150 nm, and is, for example, 120 nm. Length L2 of major axis 34 is, for example, 100 nm to 355 nm, and is, for example, 280 nm.

The ratio of the area of one hole 30 to an area a² of one square lattice (area filling ratio) is, for example, 3% to 30%.

Voltage is applied to photonic-crystal surface emitting laser 100 from electrode 26 and electrode 28. Active layer 18 has an optical gain and generates light when carriers are injected. Since photonic crystal layer 14 has the plurality of holes 30 periodically disposed, the refractive index also periodically changes. Light is Bragg-diffracted in a plane of photonic crystal layer 14. Light having the wavelength corresponding to the period of holes 30 is amplified, and laser oscillation occurs. The laser light is emitted in the normal direction (Z-axis direction) of photonic crystal layer 14. In the example of FIG. 1, a lower surface of electrode 26 is mirror-finished to reflect light. Opening 28a of electrode 28 serves as a light emitting portion (aperture), and light is emitted from the aperture.

### (Method of Manufacturing)

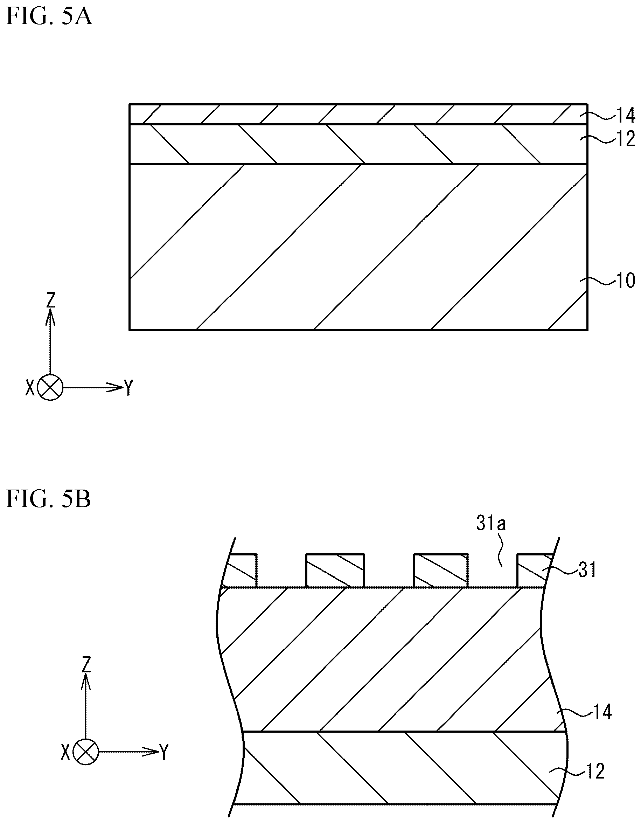

FIGs. 5A to 7B are cross-sectional views each illustrating a method of manufacturing photonic-crystal surface emitting laser 100. As illustrated in FIG. 5A, cladding layer 12 and photonic crystal layer 14 are epitaxially grown in this order on substrate 10 by, for example, a Metal Oxide Chemical Vapor Deposition (MOCVD) method. In this process, the base material (InGaAsP) of photonic crystal layer 14 is formed, but hole 30 is not formed.

FIGs. 5B to 6B are enlarged views as in FIG. 3. As illustrated in FIG. 5B, a mask 31 is formed on the upper plane of photonic crystal layer 14. Mask 31 is formed of an insulator such as SiN. An insulating film is formed on the upper plane of photonic crystal layer 14. A resist pattern is formed by an electron beam or the like, and the resist pattern is transferred to the insulating film, thereby forming mask 31. Mask 31 has a plurality of openings 31a. The upper plane of photonic crystal layer 14 is exposed from opening 31a. The planar shape of opening 31a is elliptical corresponding to hole 30. A minor axis of opening 31a is oriented to the <110> direction. A major axis is oriented to the <1-10> direction.

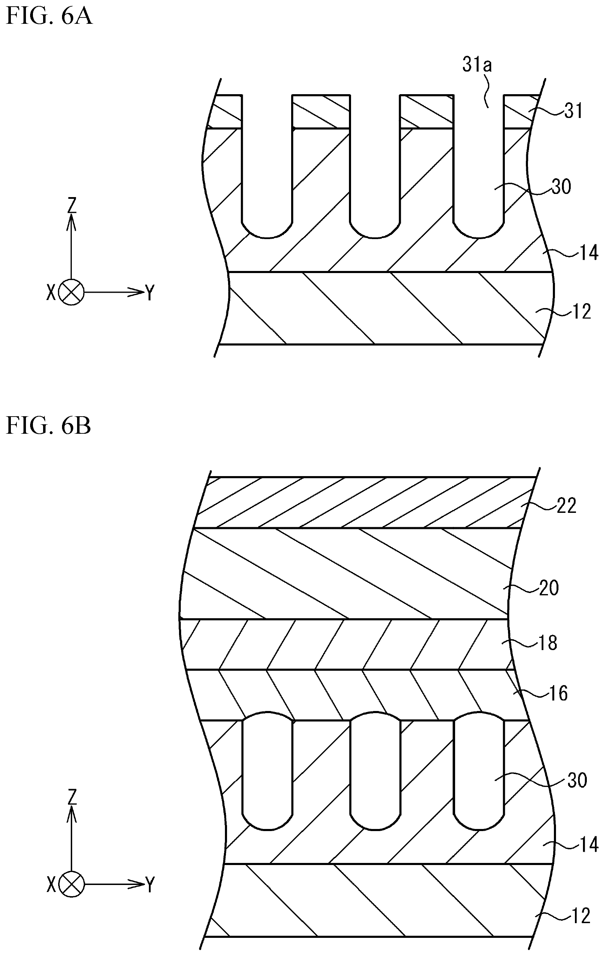

As illustrated in FIG. 6A, the plurality of holes 30 are formed in photonic crystal layer 14 by Reactive Ion Etching (RIE) or the like. The etching proceeds, for example, partway into photonic crystal layer 14, and does not proceed to a lower plane of photonic crystal layer 14. Hole 30 becomes elliptical corresponding to opening 31a (see FIGs. 4A and 4B). After the etching is completed, mask 31 is removed.

As illustrated in FIG. 6B, cladding layer 16, active layer 18, cladding layer 20, and contact layer 22 are epitaxially grown on photonic crystal layer 14. Hole 30 is closed by cladding layer 16. The inside of hole 30 is not filled with cladding layer 16 and is hollow.

The growth rate of cladding layer 16 in the <110> direction is larger than the growth rate in the <100> direction and the growth rate in the <1-10> direction. As illustrated in FIG. 4B, minor axis 32 of hole 30 is parallel to the <110> direction. Cladding layer 16 grows fast in the direction of minor axis 32 of hole 30. Cladding layer 16 grown in the <110> direction closes an upper side of hole 30. Active layer 18, cladding layer 20, and contact layer 22 are grown on cladding layer 16.

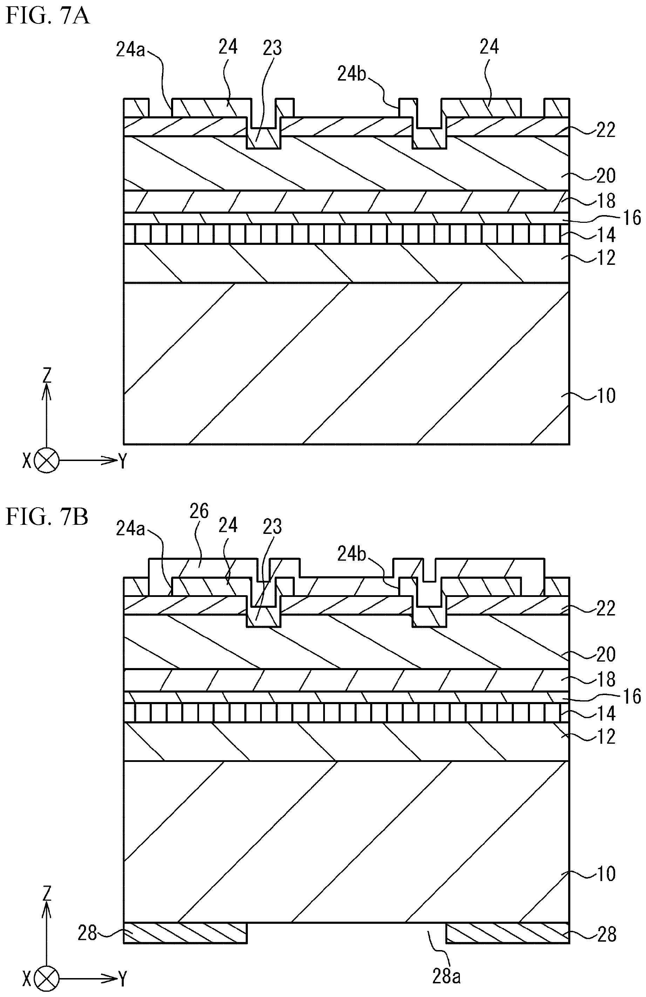

As illustrated in FIG. 7A, insulating film 24 is formed by, for example, a plasma CVD method. Recess 23 is provided in insulating film 24 by resist patterning (resist pattern is not illustrated), etching or the like.

As illustrated in FIG. 7B, electrode 26 is provided on or above contact layer 22, for example by vacuum deposition and lift-off. Electrode 28 is provided on a lower surface of substrate 10. Photonic-crystal surface emitting laser 100 is formed by the above-described process.

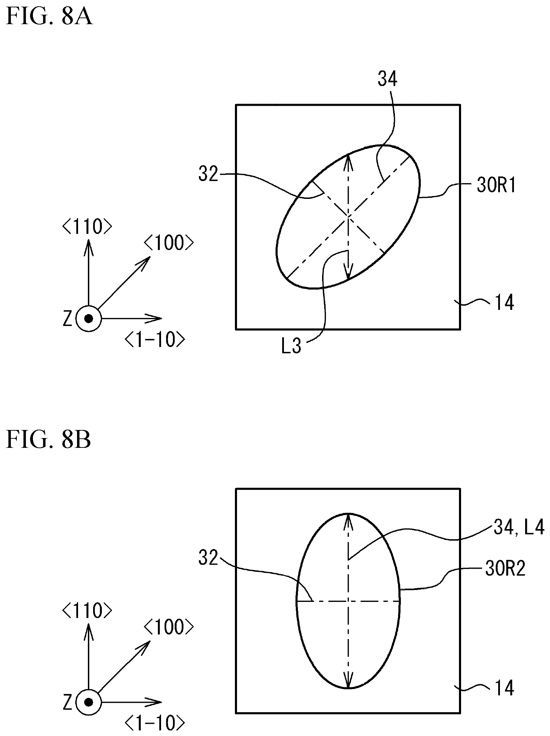

FIG. 8A is a plan view illustrating a photonic-crystal surface emitting laser according to a first comparative example, and illustrates a portion of photonic crystal layer 14 including one hole 30R1. As illustrated in FIG. 8A, major axis 34 of hole 30R1 is oriented to the <100> direction. In other words, hole 30R1 is oriented to be rotated by 45 degrees to the left from hole 30 in FIG. 3B. As in the example of FIGs. 4A and 4B, holes 30 are disposed in a square lattice with one side 400 nm. A length L3 of hole 30R1 in the <110> direction is 170 nm, which is larger than length L1 of minor axis 32 of hole 30 in FIG. 4B.

FIG. 8B is a plan view illustrating a photonic-crystal surface emitting laser according to a second comparative example, and illustrates a portion of photonic crystal layer 14 including one hole 30R2. As illustrated in FIG. 8B, major axis 34 of hole 30R1 is oriented to the <110> direction. In other words, hole 30R2 is oriented to be rotated by 90 degrees to the left from hole 30 in FIG. 3B. As in the example of FIGs. 4A and 4B, holes 30 are disposed in a square lattice with one side 400 nm. A length L4 of hole 30R2 in the <110> direction is equal to the length of major axis 34, for example, 280 nm, and is larger than length L1 of minor axis 32 of hole 30 in FIG. 4B.

The crystal growth of the semiconductor layer over the hole progresses from an edge of the hole toward an upper portion of the hole so as to close the hole. Group III-V semiconductors such as InP-based semiconductors and GaAs-based semiconductors have a low growth rate in the <1-10> direction and a high growth rate in the <110> direction due to the atomic structure. When a GaAs-based semiconductor layer is grown over an hole having a shape with a major axis and a minor axis, crystal defects (dislocation) is likely to occur when there is a difference in growth rate between the major axis and the minor axis. When a GaAs-based semiconductor is grown over hole 30R1, the difference between the growth rate for the major axis and the growth rate for the minor axis is small. Thus, the cladding layer with less dislocation can be grown. That is, hole 30R1 can be closed by a good GaAs-based semiconductor layer with less dislocation. However, the inventors have found that semiconductor layers different from the GaAs-based semiconductor layers have different crystal growth aspects due to the difference in material. For example, in an InP-based semiconductor, closing the holes in a short time is more effective in suppressing crystal defects in the cladding layer than reducing the difference between the growth rate for the major axis and the growth rate for the minor axis. For example, cladding layer 16 of InP has a low growth rate in the <1-10> direction and a high growth rate in the <110> direction. Length L3 in the <110> direction in the example of FIG. 8A is larger than length L1 in the example of FIG. 4. Length L4 in the <110> direction in the example of FIG. 8B is larger than length L1. It takes a long time until the hole is closed. In the experiment using the InP-based semiconductor, dislocation may have occurred in cladding layer 16 over hole 30R1 and cladding layer 16 over hole 30R2. Dislocation in cladding layer 16 may deteriorate the characteristics of photonic-crystal surface emitting laser.

According to the first embodiment, photonic crystal layer 14 includes the plurality of holes 30. Length L1 of hole 30 in the <110> direction is smaller than length L2 of hole 30 in the <1-10> direction. The growth rate of cladding layer 16 in the <110> direction is higher than the growth rate in the <100> direction and the growth rate in the <1-10> direction. Cladding layer 16 grows fast in the <110> direction, so that hole 30 is closed quickly by cladding layer 16. Since hole 30 is closed, dislocation is less likely to occur in cladding layer 16. Deterioration of characteristics of photonic-crystal surface emitting laser 100 due to dislocation is suppressed. The suppression of dislocation improves the crystallinity of cladding layer 16 and the layers on or above cladding layer 16 (such as active layer 18). The characteristics of photonic-crystal surface emitting laser 100 are improved. For example, the threshold current can be reduced and the output can be improved. Long-term reliability is also improved.

As illustrated in FIG. 4B, the planar shape of hole 30 is an ellipse, which has two symmetric axes (minor axis 32 and major axis 34). Length L1 of hole 30 in the direction of minor axis 32 is smaller than length L2 of hole 30 in the direction of major axis 34. Minor axis 32 is parallel to the <110> direction. Since the direction in which the growth rate of cladding layer 16 is high and the direction of minor axis 32 of hole 30 are parallel, cladding layer 16 grows faster in the direction of minor axis 32 than in other directions. Hole 30 is closed quickly by cladding layer 16. This can suppress dislocation of the semiconductor layer such as cladding layer 16. The characteristics of photonic-crystal surface emitting laser 100 are improved by suppressing the dislocation.

As illustrated in FIG. 1, photonic crystal layer 14, cladding layer 16, and active layer 18 are stacked in this order. Hole 30 of photonic crystal layer 14 is closed by cladding layer 16. Active layer 18 is grown on cladding layer 16. Since hole 30 is closed quickly, dislocation is less likely to occur in cladding layer 16 and active layer 18 on or above photonic crystal layer 14. A surface of cladding layer 16 is flatter than a surface of photonic crystal layer 14. Active layer 18 has high crystallinity because it is grown on a planar surface.

Cladding layer 16 grows fast and closes hole 30, thereby suppressing the occurrence of dislocation in cladding layer 16. Even when cladding layer 16 is made thin, for example, 50 nm to 200 nm, the occurrence of dislocation is suppressed. By making cladding layer 16 thinner, the distance between active layer 18 and photonic crystal layer 14 is reduced. The optical coupling between active layer 18 and photonic crystal layer 14 is strengthened. Light generated in active layer 18 is strongly influenced by photonic crystal layer 14. The diffraction of light facilitates laser oscillation at a desired wavelength. That is, the output of the laser beam increases.

As illustrated in FIG. 4A, the plurality of holes 30 are arranged in a square lattice. The ratio of the area of hole 30 to the area of one square lattice is 5% to 20%. Laser oscillation is possible by diffracting light. The area ratio of hole 30 may be, for example, 3% or more, 10% or more, 15% or less, or 30% or less.

When the resonant wavelength is 1300 nm, a length a of one side of the square lattice is 400 nm. Length L1 of minor axis 32 of hole 30 is 60 nm to 150 nm. Length L2 of major axis 34 is 100 nm to 355 nm. Length L1 of minor axis 32 is within the above range and is smaller than length L2. The dimensions may be changed in accordance with the resonant wavelength.

Photonic crystal layer 14 is formed of, for example, InGaAsP or AlInGaAs. Photonic crystal layer 14 is a semiconductor layer containing the compound semiconductor as described above. Cladding layer 16 contains InP, and is formed of, for example, n-type InP. The growth rate varies in accordance with the direction of the crystal. Cladding layer 16 has a high growth rate in the <110> direction. By orienting minor axis 32 of hole 30 to the <110> direction, hole 30 can be closed quickly by cladding layer 16. Hole 30 can be closed quickly by growing a semiconductor having a high growth rate in the <110> direction, for example, InP, on photonic crystal layer 14.

Hole 30 may extend partway into photonic crystal layer 14 as illustrated in FIG. 2, or may extend to cladding layer 12 through photonic crystal layer 14.

### (Modification)

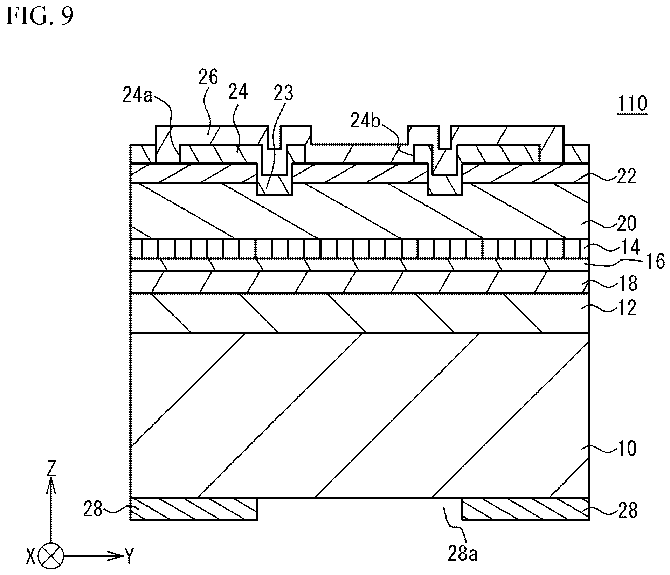

FIG. 9 is a cross-sectional view illustrating a photonic-crystal surface emitting laser 110 according to a modification. The description of the same configuration as that of the first embodiment will be omitted. As illustrated in FIG. 9, substrate 10, cladding layer 12, active layer 18, cladding layer 16, photonic crystal layer 14, and cladding layer 20 are stacked in this order. Active layer 18 is provided between cladding layer 12 and photonic crystal layer 14.

Photonic crystal layer 14 has elliptical holes 30 as illustrated in FIGs. 4A and 4B. Minor axis 32 is oriented to the <110> direction. Since hole 30 can be closed quickly, occurrence of dislocation is suppressed. The characteristics of photonic-crystal surface emitting laser 110 are improved.

### <Second Embodiment>

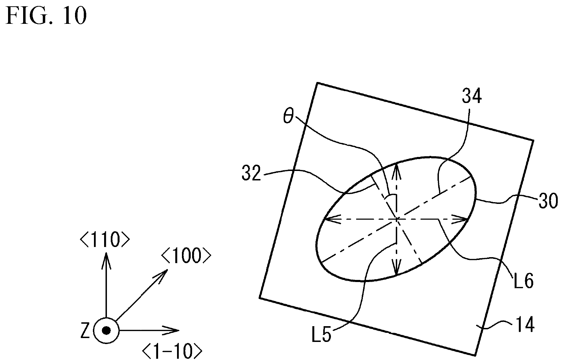

FIG. 10 is a plan view illustrating a photonic-crystal surface emitting laser according to a second embodiment, in which hole 30 in photonic crystal layer 14 is enlarged. The description of the same configuration as that of the first embodiment will be omitted. Hole 30 and a square lattice in FIG. 10 are provided at positions rotated to the left by an angle θ from hole 30 and the square lattice in FIG. 4B. Minor axis 32 of hole 30 is inclined with respect to the <110> direction. The angle θ between minor axis 32 and the <110> direction is, for example, 30 degrees or less.

As in the example of FIGs. 4A and 4B, holes 30 are disposed in a square lattice with one side 400 nm. A length L5 of hole 30 in the <110> direction in FIG. 10 is 139 nm, which is smaller than a length L6 in the <1-10> direction.

According to the second embodiment, length L5 of hole 30 in the <110> direction is smaller than length L6 of hole 30 in the <1-10> direction. Cladding layer 16 grows fast in the <110> direction, so that hole 30 is closed. Since hole 30 is closed, dislocation is less likely to occur in cladding layer 16. The deterioration of characteristics of the photonic-crystal surface emitting laser is suppressed.

The angle θ between minor axis 32 and the <110> direction is, for example, 30 degrees or less. By setting the angle θ to 30 degrees or less, length L5 is reduced. Cladding layer 16 allows hole 30 to be closed quickly. The angle θ may be, for example, 35 degrees or less, 20 degrees or less, 10 degrees or less, or 5 degrees or less. The smaller the angle θ, the closer minor axis 32 is to the <110> direction. The smaller the angle 0, the smaller the length L5 illustrated in FIG. 10. When the angle θ is 0 degrees, minor axis 32 is parallel to the <110> direction as illustrated in FIG. 4B. When θ is equal to 0 degrees, length L5 is equal to length L1 in FIG. 4B. The smaller the length L5, the quickly the hole 30 can be closed.

The shape of hole 30 is determined by the shape of opening 31a of mask 31 used for etching. By making opening 31a elliptical, hole 30 also becomes elliptical. By making the minor axis of opening 31a parallel to the <110> direction, minor axis 32 of hole 30 also becomes parallel to the <110> direction as illustrated in FIG. 4B. When the minor axis of opening 31a is inclined by the angle θ from the <110> direction, minor axis 32 of hole 30 is also inclined by the angle θ from the <110> direction as illustrated in FIG. 10.

Minor axis 32 in the example of FIG. 10 is oriented to a direction rotated counterclockwise by the angle θ from the <110> direction. Minor axis 32 may be oriented to a direction rotated clockwise by the angle θ from the <110> direction.

### <Third Embodiment>

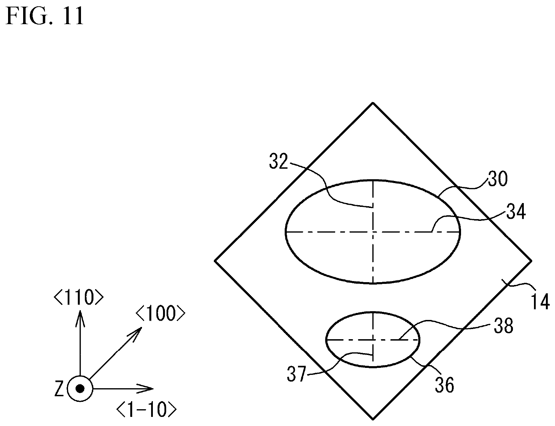

FIG. 11 is a plan view illustrating a photonic-crystal surface emitting laser according to a third embodiment, and illustrates one square lattice of photonic crystal layer 14. The description of the same configuration as that of the first embodiment will be omitted. Two holes 30 (first hole) and 36 (second hole) are provided in one square lattice. The planar shape of each of hole 30 and hole 36 is elliptical.

Hole 36 is smaller than hole 30, and is similar to hole 30. Minor axis 32 of hole 30 and a minor axis 37 of hole 36 are parallel to the <110> direction. Major axis 34 of hole 30 and a major axis 38 of hole 36 are parallel to the <1-10> direction. Hole 30 has, for example, the same shape as that of the example of FIG. 4B. Minor axis 37 of hole 36 is shorter than minor axis 32 of hole 30. Major axis 38 of hole 36 is shorter than major axis 34 of hole 30.

According to the third embodiment, the minor axis of hole 30 and the minor axis of hole 36 are parallel to the <110> direction. Cladding layer 16 has a high growth rate in the <110> direction. Holes 30 and 36 are closed quickly by cladding layer 16. Dislocation is suppressed, and deterioration of characteristics of the photonic-crystal surface emitting laser is suppressed.

Photonic crystal layer 14 has two holes 30 and 36 in one square lattice. The number of holes provided in one square lattice may be two or more, for example, three or more, or four or more. In either of both of holes, a length in the <110> direction is smaller than a length in the <1-10> direction. For example, the planar shape of either or both of the plurality of holes is set to an ellipse. The minor axis of the elliptical hole is oriented in a range of the angle θ or less from the <110> direction.

In FIG. 11, both of two holes 30 and 36 are elliptical. Either or both of two holes 30 and 36 may have a shape other than elliptical. The shape other than elliptical includes polygonal as illustrated in the fourth to sixth embodiments.

### <Fourth Embodiment>

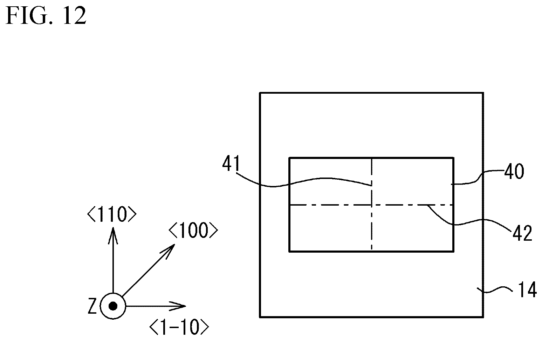

FIG. 12 is a plan view illustrating a photonic-crystal surface emitting laser according to a fourth embodiment, and illustrates one square lattice of photonic crystal layer 14. The description of the same configuration as that of the first embodiment will be omitted.

An hole 40 is provided in photonic crystal layer 14. The planar shape of hole 40 is rectangular. Hole 40 has a minor axis 41 and a major axis 42. Minor axis 41 is shorter than major axis 42. Minor axis 41 is parallel to the <110> direction. Major axis 42 is parallel to the <1-10> direction.

According to the fourth embodiment, minor axis 41 of hole 40 is parallel to the <110> direction. Cladding layer 16 grows fast in the <110> direction, so that holes 40 are closed quickly by cladding layer 16. Since hole 40 is closed, dislocation is less likely to occur in cladding layer 16. The suppression of dislocation suppresses deterioration of characteristics of the photonic-crystal surface emitting laser.

### <Fifth Embodiment>

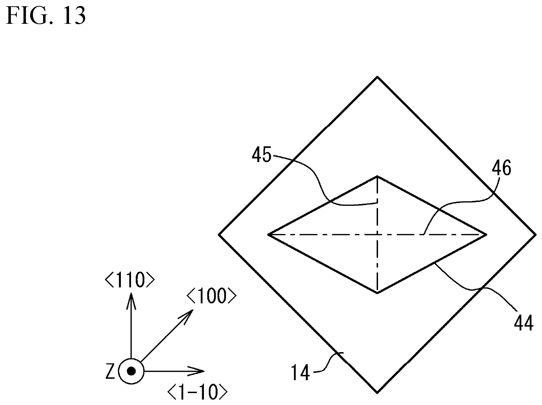

FIG. 13 is a plan view illustrating a photonic-crystal surface emitting laser according to a fifth embodiment, and illustrates one square lattice of photonic crystal layer 14. The description of the same configuration as that of the first embodiment will be omitted.

An hole 44 is provided in photonic crystal layer 14. The planar shape of hole 44 is a rhombus. Hole 44 has a minor axis 45 and a major axis 46. Minor axis 45 is shorter than major axis 46. Minor axis 45 is parallel to the <110> direction. Major axis 46 is parallel to <1-10> the direction.

According to the fifth embodiment, minor axis 45 of hole 44 is parallel to the <110> direction. Cladding layer 16 grows fast in the <110> direction, so that hole 44 is closed quickly by cladding layer 16. Since hole 44 is closed, dislocation is less likely to occur in cladding layer 16. The suppression of dislocation suppresses deterioration of characteristics of the photonic-crystal surface emitting laser.

In the first embodiment to the fifth embodiment, the hole has two symmetric axes. The hole is line symmetric with respect to each of the two symmetric axes. The hole may be strictly line symmetric or may be deviated from the line symmetric within a range of manufacturing errors, for example. The shape of the hole is determined by the accuracy of etching or the like. The holes may be slightly shifted from the line symmetric in accordance with the accuracy of etching.

### <Sixth Embodiment>

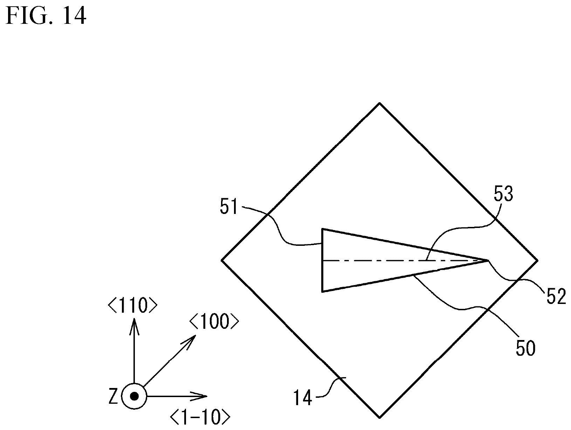

FIG. 14 is a plan view illustrating a photonic-crystal surface emitting laser according to a sixth embodiment, and illustrates one square lattice of photonic crystal layer 14. The description of the same configuration as that of the first embodiment will be omitted.

An hole 50 is provided in photonic crystal layer 14. The planar shape of hole 50 is a triangle. One side 51 of hole 50 is parallel to the <110> direction. Among the vertices of hole 50, the vertex facing side 51 is defined as a vertex 52. A line segment passing through vertex 52 and bisecting side 51 is defined as a line segment 53. Line segment 53 is parallel to the <1-10> direction. Side 51 is shorter than line segment 53.

According to the sixth embodiment, side 51 of hole 50 is parallel to the <110> direction and is shorter than line segment 53 in the <1-10> direction. Cladding layer 16 grows fast in the <110> direction, so that hole 50 is closed quickly by cladding layer 16. Since holes 50 are closed, dislocation is less likely to occur in cladding layer 16. The suppression of dislocation suppresses deterioration of characteristics of the photonic-crystal surface emitting laser.

As described in the first embodiment, the planar shape of the hole may be an ellipse. As described in the fourth embodiment to the sixth embodiment, the planar shape of the hole may be polygonal. The vertex of the polygonal may include a curve.

Although the embodiments of the present disclosure have been described in detail above, the present disclosure is not limited to the specific embodiments, and various modifications and changes can be made within the scope of the gist of the present disclosure described in the claims.

### REFERENCE SIGNS LIST

10 substrate
12, 16, 20 cladding layer
14 photonic crystal layer
18 active layer
22 contact layer
23 recess
24 insulating film
24a, 24b, 28a, 31a opening
26, 28 electrode
31 mask
30, 30R1, 30R2, 36, 40, 50 hole
32, 37, 45 minor axis
34, 38, 46 major axis
51 side
52 vertex
53 line segment
100, 110 photonic-crystal surface emitting laser

## Claims

1. A photonic-crystal surface emitting laser comprising:
an active layer;
a photonic crystal layer; and
a first semiconductor layer,
wherein the photonic crystal layer includes a base material and a plurality of holes periodically disposed in the base material,
the plurality of holes extends from one plane of the photonic crystal layer to an opposite plane of the photonic crystal layer,
the first semiconductor layer is provided on the one plane of the photonic crystal layer, and
a length of each of the plurality of holes in a <110> direction of the photonic crystal layer is smaller than a length of each of the plurality of holes in a <1-10> direction of the photonic crystal layer.

2. The photonic-crystal surface emitting laser according to claim 1,
wherein a planar shape of each of the plurality of holes has a first symmetric axis and a second symmetric axis,
a length of each of the plurality of holes in a direction of the first symmetric axis is smaller than a length of each of the plurality of holes in a direction of the second symmetric axis, and
an angle between the first symmetric axis and the <110> direction of the photonic crystal layer is 30° or less.

3. The photonic-crystal surface emitting laser according to claim 2,
wherein the first symmetric axis is parallel to the <110> direction.

4. The photonic-crystal surface emitting laser according to claim 3,
wherein the planar shape of each of the plurality of holes is elliptical, and
a minor axis of each of the plurality of holes is parallel to the <110>.

5. The photonic-crystal surface emitting laser according to claim 1 or 2,
wherein the photonic crystal layer, the first semiconductor layer, and the photonic crystal layer are stacked in order.

6. The photonic-crystal surface emitting laser according to claim 1 or 2,
wherein the active layer, the photonic crystal layer, and the first semiconductor layer are stacked in order.

7. The photonic-crystal surface emitting laser according to claim 1 or 2,
wherein the plurality of holes are disposed in a square lattice in a plane of the photonic crystal layer, and
a ratio of each of the plurality of holes to an area of the square lattice is 3% to 30%.

8. The photonic-crystal surface emitting laser according to claim 1 or 2,
wherein the photonic crystal layer includes a plurality of first holes and a plurality of second holes,
the plurality of first holes and the plurality of second holes are periodically disposed in the base material, and
either or both of the plurality of the first holes and the plurality of the second holes each have a length in the <110> direction of the photonic crystal layer smaller than a length in the <1-10> direction of the photonic crystal layer.

9. The photonic-crystal surface emitting laser according to claim 1 or 2,
wherein the photonic-crystal layer contains indium gallium arsenide phosphide or aluminum indium gallium arsenide, and
the first semiconductor layer contains indium phosphide.

10. A method of manufacturing a photonic-crystal surface emitting laser, the method comprising:
forming a plurality of holes periodically disposed in a base material of a photonic crystal layer, the plurality of holes extending from one plane of the photonic crystal layer to an opposite plane of the photonic crystal layer;
forming a first semiconductor layer on the one plane of the photonic crystal layer; and
forming an active layer,
wherein a length of each of the plurality of holes in a <110> direction of the photonic crystal layer is smaller than a length of each of the plurality of holes in a <1-10> direction of the photonic crystal layer.
